# EUROPEAN PATENT APPLICATION

(11) **EP 4 694 599 A1**
(43) Date of publication of application: **11.02.2026**
(21) Application number: 24796220.2
(22) Date of filing: 26.04.2024
(51) Int. Cl.: H05K 7/20

(54) **HEAT DISSIPATOR, HEAT DISSIPATION APPARATUS, AND ELECTRONIC DEVICE**

(30) Priority: 28.04.2023 CN 202310485514
(71) Applicant: Huawei Technologies Co., Ltd., Shenzhen, Guangdong 518129 (CN)
(72) Inventor: DU, Yang, Shenzhen, Guangdong 518129 (CN); BAI, Lu, Shenzhen, Guangdong 518129 (CN); LI, Dingfang, Shenzhen, Guangdong 518129 (CN)
(74) Representative: Körber, Martin Hans
(86) International application number: PCT/CN2024/089991
(87) International publication number: WO 2024/222846

(57) **Abstract**

This application provides a heat dissipator, a heat dissipation apparatus, and an electronic device, and relates to the field of electronic device technologies, to resolve a technical problem of poor heat dissipation performance of the heat dissipator. The heat dissipator provided in this application includes a base body, and a liquid distribution cavity, a liquid collection cavity, and a heat exchange cavity that are located in the base body. The base body is provided with a liquid inlet end and a liquid outlet end. The liquid distribution cavity is located in the base body, and a first end of the liquid distribution cavity is communicated with the liquid inlet end. The liquid collection cavity is located in the base body, and a first end of the liquid collection cavity is communicated with the liquid outlet end. The heat exchange cavity is located in the base body and is provided with a liquid inlet and a liquid outlet. The liquid inlet is communicated with the liquid distribution cavity, and the liquid outlet is communicated with the liquid collection cavity. A plurality of heat exchange cavities are provided, and an outer surface of each of the heat exchange cavities is provided with a heat dissipation surface. In the heat dissipator provided in embodiments of this application, at least two heat exchange cavities may be provided, and an outer surface of each of the heat exchange cavities is provided with a heat dissipation surface. Therefore, the heat dissipator can cool at least two to-be-cooled components. This helps reduce a quantity of configured heat dissipators and reduce flow resistance.

## Description

### CROSS-REFERENCE TO RELATED APPLICATIONS

This application claims priority to Chinese Patent Application No. 202310485514.X, filed with the China National Intellectual Property Administration on April 28, 2023 and entitled "HEAT DISSIPATOR, HEAT DISSIPATION APPARATUS, AND ELECTRONIC DEVICE", which is incorporated herein by reference in its entirety.

### TECHNICAL FIELD

This application relates to the field of electronic device technologies, and in particular, to a heat dissipator, a heat dissipation apparatus, and an electronic device.

### BACKGROUND

An electronic device generally includes a heat generating component, for example, a chip. The chip generates heat when working normally. To ensure that the chip remains within a normal temperature range, heat dissipation is required for the chip. With continuous improvement of computing power of the chip, the heat generated by the chip increases significantly. Currently, heat dissipation of the chip is mainly performed in two manners: air cooling and liquid cooling. Compared with the air cooling manner, the liquid cooling manner has advantages such as high heat dissipation efficiency and a compact structure. Therefore, the liquid cooling manner gradually becomes a mainstream solution.

In current liquid cooling manners, generally, a plurality of heat dissipators are connected in series, and each heat dissipator can dissipate heat for only one chip. This results in occupation of a large amount of space and uneven flow distribution.

### SUMMARY

This application provides a heat dissipator with a compact structure and relatively good heat dissipation performance, a heat dissipation apparatus, and an electronic device.

According to a first aspect, this application provides a heat dissipator, where the heat dissipator may include a base body, and a liquid distribution cavity, a liquid collection cavity, and a heat exchange cavity that are located in the base body. The base body is provided with a liquid inlet end and a liquid outlet end. The liquid distribution cavity is located in the base body, and a first end of the liquid distribution cavity is communicated with the liquid inlet end. The liquid collection cavity is located in the base body, and a first end of the liquid collection cavity is communicated with the liquid outlet end. The heat exchange cavity is located in the base body and is provided with a liquid inlet and a liquid outlet, the liquid inlet is communicated with the liquid distribution cavity, and the liquid outlet is communicated with the liquid collection cavity. A plurality of heat exchange cavities are provided, and an outer surface of each of the heat exchange cavities is provided with a heat dissipation surface. In the heat dissipator provided in embodiments of this application, at least two heat exchange cavities may be provided, and an outer surface of each of the heat exchange cavities is provided with a heat dissipation surface. Therefore, the heat dissipator can cool at least two to-be-cooled components. This helps reduce a quantity of configured heat dissipators or can reduce a size of a heat dissipator that cools a plurality of to-be-cooled components, and helps reduce flow resistance.

In an example, the heat dissipator may further include a cooling plate. The base body is provided with a window in communication with the heat exchange cavity, the cooling plate seals the window, and the heat dissipation surface is located on a surface that is of the cooling plate and that is away from the heat exchange cavity. The cooling plate is equipped, so that cooling efficiency of the heat dissipator can be effectively improved, thereby enabling more efficient cooling of a to-be-cooled component.

In an example, for one heat exchange cavity, the base body is provided with a plurality of windows in communication with the heat exchange cavity, and each of the windows is provided with a cooling plate that seals the window. It may be understood that, for one heat exchange cavity, a quantity of heat dissipation surfaces may be increased by increasing a quantity of corresponding cooling plates, to provide effective heat dissipation surfaces for more to-be-cooled components. This helps reduce a quantity of configured heat dissipators.

During specific disposition, the heat dissipator may further include a plurality of spacer plates. The plurality of spacer plates are disposed in a one-to-one correspondence with the plurality of heat exchange cavities. A liquid inlet and a liquid outlet of each of the heat exchange cavities may be provided on a spacer plate, and the spacer plate is located between the corresponding heat exchange cavity and the liquid distribution cavity and between the corresponding heat exchange cavity and the liquid collection cavity. In this way, the spacer plate can effectively separate the heat exchange cavity, the liquid distribution cavity, and the liquid collection cavity. In addition, during manufacturing, the spacer plate may be separately manufactured and then assembled with the base body, which improves convenience during manufacturing.

In an example, the spacer plate may have a first plate surface facing the heat exchange cavity, and the cooling plate may have a second plate surface facing the heat exchange cavity. A plurality of protruding fins are provided on the second plate surface, and a channel for a coolant to flow through is provided between adjacent fins. A top of each of the fins is abutted against the first plate surface. The fins are disposed, so that an area of heat exchange between the cooling plate and a cooling medium can be effectively improved. This helps improve heat dissipation performance of the heat dissipator. In addition, the top of the fin is abutted against the first plate surface. As a result, a gap between the cooling plate and the spacer plate can be effectively reduced, so that the cooling medium can flow through the channel between adjacent fins.

During specific disposition, a protrusion or a groove may be provided on the second plate surface. The top of the fin is abutted against the second plate surface. Therefore, lengths of different fins are changed after the protrusion or the groove is provided on the second plate surface. Alternatively, grooves or protrusions are provided on the top of some fins. The protrusion or the groove is provided, so that flow resistance of a contact surface between the spacer plate and the cooling plate can be increased. This facilitates flow of more cooling media through the channel between adjacent fins, and therefore helps improve efficiency of heat exchange between the cooling medium and the cooling plate.

During specific disposition, the base body may be a hollow body, a baffle plate is disposed in the base body, and the baffle plate separates the liquid collection cavity from the liquid distribution cavity. Alternatively, it may be understood that both the liquid collection cavity and the liquid distribution cavity are located in hollow space of the base body, and the baffle plate may effectively separate the hollow space to form a relatively independent liquid collection cavity and liquid distribution cavity.

In an example, the heat dissipator may be provided with two heat exchange cavities, and the two heat exchange cavities are symmetric to each other. The baffle plate may be a U-shaped plate, and an opening end of the baffle plate is communicated with the liquid inlet end. The heat dissipator includes a first spacer plate and a second spacer plate, the first spacer plate is located on a first side edge of the baffle plate and is attached to the first side edge, and the second spacer plate is located on a second side edge of the baffle plate and is attached to the second side edge. The liquid collection cavity and the liquid distribution cavity are on one side of the first spacer plate, and one of the heat exchange cavities is on the other side of the first spacer plate. The liquid collection cavity and the liquid distribution cavity are on one side of the second spacer plate, and the other of the heat exchange cavities is on the other side of the second spacer plate.

According to a second aspect, this application further provides a heat dissipation apparatus, where the heat dissipation apparatus may include a frame and at least one heat dissipator, and the heat dissipator is disposed in the frame. The frame is provided with a liquid inlet pipeline and a liquid outlet pipeline, the liquid inlet pipeline is communicated with the liquid inlet end, and the liquid outlet pipeline is communicated with the liquid outlet end. The heat dissipation apparatus provided in this application uses the heat dissipator and therefore can provide more heat dissipation surfaces, featuring a compact structure and good heat dissipation performance. In addition, this helps reduce flow resistance of the entire heat dissipation apparatus.

According to a third aspect, this application further provides an electronic device, including a to-be-cooled component, and the heat dissipator according to the first aspect or the heat dissipation apparatus according to the second aspect. The to-be-cooled component may be thermally attached to the heat dissipation surface, so that heat can be dissipated by the heat dissipator. In the electronic device provided in this application, the heat dissipator or the heat dissipation apparatus is used, so that more to-be-cooled components can be integrated in effective space. This helps improve heat dissipation efficiency of the electronic device.

### BRIEF DESCRIPTION OF DRAWINGS

FIG. 1 is a perspective view of a structure of a heat dissipator according to an embodiment of this application;
FIG. 2 is a sectional view of a structure of a heat dissipator according to an embodiment of this application;
FIG. 3 is a diagram illustrating a flow path of a cooling medium in a heat dissipator according to an embodiment of this application;
FIG. 4 is an exploded view of a structure of a heat dissipator according to an embodiment of this application;
FIG. 5 is a sectional view of a structure of a heat dissipator according to an embodiment of this application;
FIG. 6 is a partial exploded view of a structure of a heat dissipator according to an embodiment of this application;
FIG. 7 is a partial exploded view of a structure of a heat dissipator according to an embodiment of this application;
FIG. 8 is a sectional view of a structure of a heat dissipator according to an embodiment of this application;
FIG. 9 is a perspective view of a structure of another heat dissipator according to an embodiment of this application;
FIG. 10 is a diagram of a structure of a heat dissipation apparatus according to an embodiment of this application; and
FIG. 11 is a side view of a structure of a heat dissipator after use according to an embodiment of this application.

### DESCRIPTION OF EMBODIMENTS

To make the objectives, technical solutions, and advantages of this application clearer, the following further describes this application in detail with reference to the accompanying drawings.

For ease of understanding of a heat dissipator provided in embodiments of this application, the following first describes application scenarios of the heat dissipator.

The heat dissipator provided in embodiments of this application may be used in various scenarios with heat dissipation requirements. For example, a data center may include devices such as a chip and a memory. With continuous development of communication technologies and increasingly higher requirements of users, a quantity of configured chips and operating power of the chips are increased significantly. The chip generates a relatively large amount of heat during normal operation. To enable the chip to work within a normal temperature range, heat dissipation is required for the chip. A liquid cooling manner has advantages such as a compact structure of a heat dissipation apparatus and high heat dissipation efficiency, and is therefore gradually widely applied. In a liquid cooling system, heat dissipation for a chip is mainly performed through a heat dissipator. Besides, for current heat dissipators, a single heat dissipator can dissipate heat for only a single chip. When there are a relatively large quantity of chips, there are also a relatively large quantity of heat dissipators configured, raising costs of using the heat dissipators. In addition, a plurality of heat dissipators are usually arranged in series, resulting in a difference in heat dissipation efficiency between different heat dissipators. This consequently reduces cooling efficiency of the entire cooling system. Moreover, the relatively large quantity of configured heat dissipators increase a size and flow resistance of the entire cooling system significantly. This also reduces the cooling efficiency of the cooling system.

In view of this, an embodiment of this application provides a heat dissipator with a compact structure and relatively good heat dissipation performance. The heat dissipator provided in this embodiment of this application can effectively dissipate heat for a plurality of to-be-cooled components (for example, chips), with relatively balanced flow distribution.

To make the objectives, technical solutions, and advantages of this application clearer, the following further describes this application in detail with reference to the accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It should be further understood that, in the following embodiments of this application, "at least one" means one, two, or more.

Reference to "an embodiment" or the like described in this specification indicates that one or more embodiments of this application include a specific feature, structure, or characteristic described with reference to the embodiment. Therefore, statements such as "in an embodiment", "in some implementations", and "in other implementations" that appear at different places in this specification do not necessarily refer to a same embodiment, but mean "one or more but not all embodiments", unless otherwise specifically emphasized in another manner. Terms "include", "have", and their variants all mean "include but are not limited to", unless otherwise specifically emphasized in another manner.

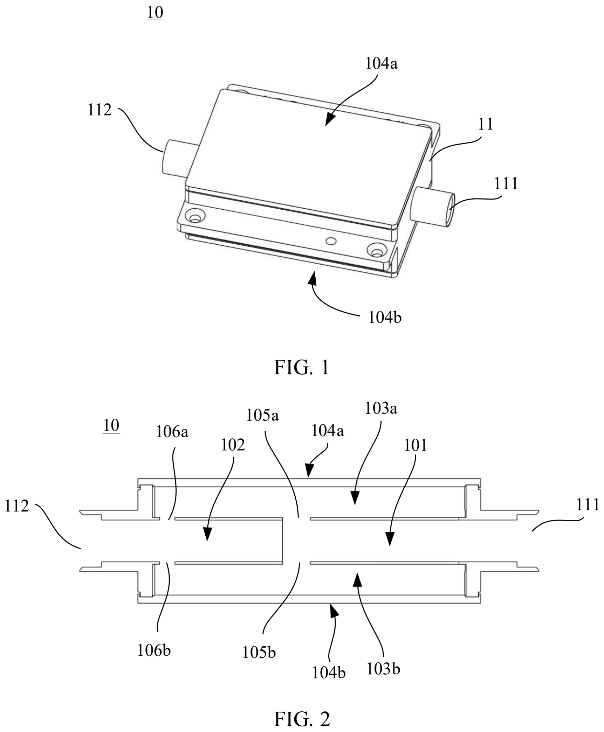

As shown in FIG. 1 and FIG. 2, in an example provided in this application, a heat dissipator 10 may include a base body 11, and a liquid distribution cavity 101, a liquid collection cavity 102, and a heat exchange cavity that are located in the base body 11. The base body 11 is provided with a liquid inlet end 111 and a liquid outlet end 112. There are two heat exchange cavities: a heat exchange cavity 103a and a heat exchange cavity 103b. Specifically, the liquid distribution cavity 101 is located in the base body 11, and a first end (for example, the right end in FIG. 2) of the liquid distribution cavity 101 is communicated with the liquid inlet end 111. After a cooling medium enters the base body 11 from the liquid inlet end 111, the liquid distribution cavity 101 may effectively split the cooling medium, thereby implementing effective flow distribution. The liquid collection cavity 102 is located in the base body 11, and a first end (for example, the left end in FIG. 2) of the liquid collection cavity 102 is communicated with the liquid outlet end 112. The liquid collection cavity 102 may be configured to effectively converge the cooling medium before the cooling medium is discharged from the liquid outlet end 112. The heat exchange cavity 103a and the heat exchange cavity 103b are located in the base body 11. The heat exchange cavity 103a is provided with a liquid inlet 105a and a liquid outlet 106a, and the heat exchange cavity 103b is provided with a liquid inlet 105b and a liquid outlet 106b. The liquid inlet 105a and the liquid inlet 105b are communicated with the liquid distribution cavity 101, and the liquid outlet 106a and the liquid outlet 106b are communicated with the liquid collection cavity 102. An outer surface of the heat exchange cavity 103a is provided with a heat dissipation surface 104a, and an outer surface of the heat exchange cavity 103b is provided with a heat dissipation surface 104b.

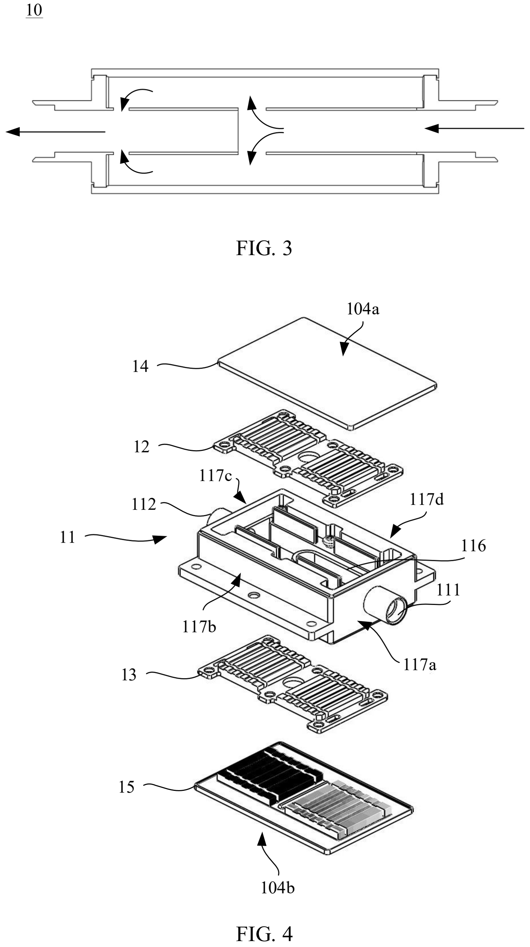

FIG. 3 shows a flow path of the cooling medium. Refer to both FIG. 2 and FIG. 3. The cooling medium may flow into the liquid distribution cavity 101 through the liquid inlet end 111. The liquid distribution cavity 101 may effectively split the cooling medium, so that the cooling medium can flow into the heat exchange cavity 103a through the liquid inlet 105a and flow into the heat exchange cavity 103b through the liquid inlet 105b. The heat dissipation surface 104a of the heat exchange cavity 103a may exchange heat with a to-be-cooled component. After flowing into the heat exchange cavity 103a, the cooling medium may take away heat received by the heat dissipation surface 104a, thereby effectively cooling the to-be-cooled component. The heat dissipation surface 104b of the heat exchange cavity 103b may exchange heat with a to-be-cooled component. After flowing into the heat exchange cavity 103b, the cooling medium may take away heat received by the heat dissipation surface 104b, thereby effectively cooling the to-be-cooled component. After exchanging heat in the heat exchange cavity 103a and the heat exchange cavity 103b, the cooling medium may flow to the liquid collection cavity 102 through the liquid outlet 106a and the liquid outlet 106b, and finally be discharged from the liquid outlet end 112. In addition, in the heat dissipator 10 provided in embodiments of this application, two heat exchange cavities may be provided, and an outer surface of each of the heat exchange cavities is provided with a heat dissipation surface. Therefore, the heat dissipator 10 can cool at least two to-be-cooled components (for example, chips). This helps reduce a quantity of configured heat dissipators 10 and reduce flow resistance.

It may be understood that, in the example provided in this application, the heat dissipator 10 includes two heat exchange cavities: the heat exchange cavity 103a and the heat exchange cavity 103b, and each of the heat exchange cavities is provided with one heat dissipation surface. Certainly, in another example, the heat dissipator 10 may alternatively include three, four, or more heat exchange cavities. In actual application, a quantity of configured heat exchange cavities may be flexibly set and adjusted according to an actual requirement. In addition, in the example provided in this application, each of the heat exchange cavities is provided with one heat dissipation surface. However, in another example, each of the heat exchange cavities may alternatively be provided with two, three, or more heat dissipation surfaces. In actual application, a quantity of configured heat dissipation surfaces and locations of the heat dissipation surfaces may be flexibly adjusted according to an actual requirement.

For ease of understanding of the technical solutions of this application, in the following example, the heat dissipator 10 including two heat exchange cavities and each of the heat exchange cavities being provided with one heat dissipation surface are used as an example for specific description.

During specific disposition, the heat dissipator 10 may have various structure types.

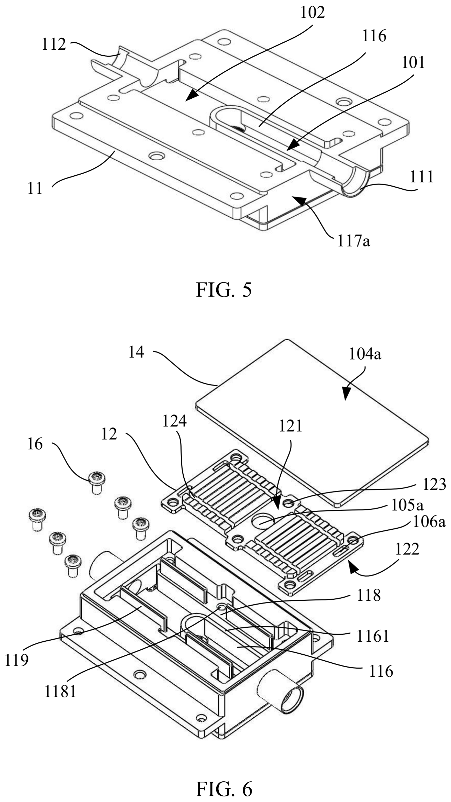

As shown in FIG. 4 and FIG. 5, in an example provided in this application, the heat dissipator 10 includes the base body 11, a first spacer plate 12 and a second spacer plate 13 that are disposed on two sides of the base body 11, and a first cooling plate 14 and a second cooling plate 15 that are disposed on the two sides of the base body 11.

The base body 11 is a hollow body. Specifically, the entire base body 11 may be a rectangular frame structure. The base body 11 has four side walls: a side wall 117a, a side wall 117b, a side wall 117c, and a side wall 117d. The side wall 117a is opposite to the side wall 117c, and the side wall 117b is opposite to the side wall 117d. A protruding pipe body is provided on an outer surface of the side wall 117a, the pipe body is communicated with space in the base body 11, and an end that is of the pipe body and that is away from the side wall 117a is the liquid inlet end 111. A protruding pipe body is provided on an outer surface of the side wall 117c, the pipe body is communicated with the space in the base body 11, and an end that is of the pipe body and that is away from the side wall 117c is the liquid outlet end 112.

As shown in FIG. 5, a U-shaped baffle plate 116 is provided in the base body 11, and an opening end (for example, the right end in FIG. 5) of the baffle plate 116 is connected to an inner surface of the side wall 117a, and is communicated with the liquid inlet end 111. It may be understood that space enclosed by an inner surface of the baffle plate 116 and the inner surface of the side wall 117a forms the liquid distribution cavity 101. Space enclosed by an outer surface of the baffle plate 116, an inner surface of the side wall 117b, an inner surface of the side wall 117c, and an inner surface of the side wall 117d forms the liquid collection cavity 102.

As shown in FIG. 6, the first spacer plate 12 is located on a first side edge 1161 of the baffle plate 116 and is attached to the first side edge 1161. The second spacer plate (not shown in FIG. 6) is located on a second side edge (not shown in FIG. 6) of the baffle plate 116 and is attached to the second side edge. The first side edge 1161 and the second side edge of the baffle plate 116 are two side edges that are opposite to each other.

The first spacer plate 12 has a first plate surface 121 and a second plate surface 122 that are opposite to each other. A mounting surface 118 is provided inside the base body 11, and the second plate surface 122 of the first spacer plate 12 faces the base body 11 and is attached to the mounting surface 118 in a sealed manner. In addition, the first side edge 1161 of the baffle plate 116 and the mounting surface 118 are located on a same surface, and the second plate surface 122 is a flat surface. Therefore, the second plate surface 122 of the first spacer plate 12 is attached to the mounting surface 118 in a sealed manner, and is also attached to the first side edge 1161 in a sealed manner.

In addition, the mounting surface 118 is provided with a threaded hole 1181, and the first spacer plate 12 is provided with a through hole 123. A bolt 16 may pass through the through hole 123 of the first spacer plate 12 and then be threaded into the threaded hole 1181 on the mounting surface 118, thereby implementing a fixed connection between the first spacer plate 12 and the base body 11. In the example in FIG. 6, there are six through holes 123 and six threaded holes 1181. In addition, six bolts 16 each pass through a corresponding through hole 123 and then are threaded into a corresponding threaded hole 1181.

It may be understood that, in another example, quantities of provided through holes 123 and threaded holes 1181 and locations of the through holes 123 and the threaded holes 1181 may be properly set according to an actual requirement. In addition, the fixed connection between the first spacer plate 12 and the base body 11 may alternatively be implemented through welding, bonding, or the like. In actual application, a manner of connection between the first spacer plate 12 and the base body 11 may be flexibly selected and set according to an actual requirement. This is not limited in this application.

In addition, a structure of the second spacer plate 13 may be the same as or similar to a structure of the first spacer plate 12. Corresponding structures for mounting the second spacer plate 13 may also be configured on the other side of the base body 11. For a structure type of the second spacer plate 13 and a connection structure between the base body 11 and the second spacer plate 13, refer to the first spacer plate 12. Details are not described herein.

In addition, as shown in FIG. 6, in the example provided in this application, a rib plate 119 (four rib plates are shown in FIG. 6) is further provided inside the base body 11. The first spacer plate 12 is provided with a through groove 124 (four through grooves are shown in FIG. 6). During assembly of the base body 11 with the first spacer plate 12, the rib plate 119 may pass through the through groove 124, so that positional accuracy between the base body 11 and the first spacer plate 12 can be improved. This helps ensure effect of assembly of the base body 11 with the first spacer plate 12.

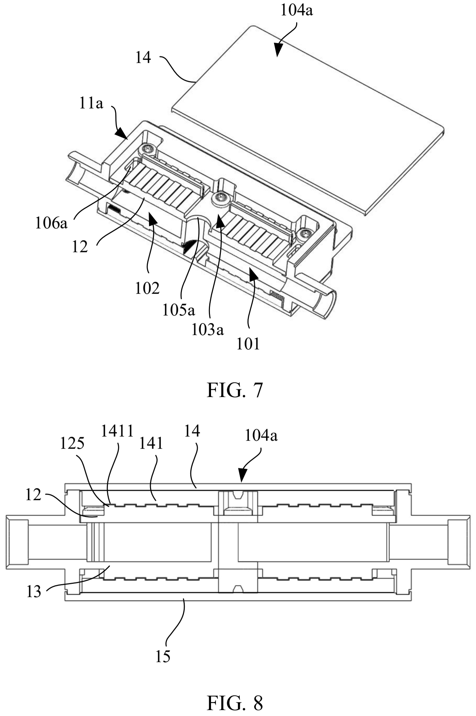

In addition, as shown in FIG. 6 and FIG. 7, one circular liquid inlet 105a and four rectangular liquid outlets 106a are provided in the middle of the first spacer plate 12. The liquid inlet 105a and the liquid outlets 106a are all through holes, and run through the first plate surface 121 and the second plate surface 122 of the first spacer plate 12. The liquid inlet 105a is communicated with the liquid distribution cavity 101, and the liquid outlets 106a are communicated with the liquid collection cavity 102.

In addition, as shown in FIG. 7, in an example provided in this application, the base body 11 is provided with a window 11a in communication with the heat exchange cavity 103a, the first cooling plate 14 seals the window 11a, and the heat dissipation surface 104a is located on a surface that is of the first cooling plate 14 and that is away from the first heat exchange cavity 103a. The liquid distribution cavity 101 and the liquid collection cavity 102 are on one side (for example, the lower side in FIG. 7) of the first spacer plate 12. The first heat exchange cavity 103a is on the other side (for example, the upper side in FIG. 7) of the first spacer plate 12.

The cooling medium may enter the liquid distribution cavity 101 from the liquid inlet end 111, and then flow into the heat exchange cavity 103a through the liquid inlet 105a of the first spacer plate 12. The cooling medium flowing into the heat exchange cavity 103a may take away heat from the first cooling plate 14, then flow into the liquid collection cavity 102 through the liquid outlets 106a, and finally be discharged from the liquid outlet end 112.

As shown in FIG. 6, in the example provided in this application, the liquid inlet 105a is located in the middle of the first spacer plate 12, and the liquid outlets 106a are distributed at the edge of the first spacer plate 12. The cooling medium flowing into the heat exchange cavity 103a from the liquid inlet 105a facilitates diffusion of the cooling medium and discharge of the cooling medium from the liquid outlet 106a. This can ensure that the cooling medium fully fills the entire heat exchange cavity 103a, avoiding a dead zone of heat dissipation and helping ensure temperature uniformity of the first cooling plate 14 (or the heat dissipation surface).

In actual application, the first cooling plate 14 and the second cooling plate 15 may have various structure types.

For example, as shown in FIG. 4, in an example provided in this application, both the first cooling plate 14 and the second cooling plate 15 are micro-channel cooling plates. A structure of the first cooling plate 14 is basically the same as a structure of the second cooling plate 15. FIG. 4 shows different plate surfaces of the first cooling plate 14 and the second cooling plate 15. Specifically, both the first cooling plate 14 and the second cooling plate 15 have two plate surfaces that are opposite to each other. One plate surface of the first cooling plate 14 may be used as the heat dissipation surface 104a, and the other plate surface faces the base body 11. One plate surface of the second cooling plate 15 may be used as the heat dissipation surface 104b, and the other plate surface faces the base body 11.

As shown in FIG. 4 and FIG. 8, a plurality of protruding fins 151 are provided on the plate surface that is of the second cooling plate 15 and that is away from the heat dissipation surface 104b, and a channel for a coolant to flow through is provided between adjacent fins 151. A top of each fin 151 is abutted against a plate surface of the second spacer plate 13. The fins 151 can increase an area of heat exchange between the cooling medium and the second cooling plate 15, thereby helping improve heat dissipation efficiency of the second cooling plate 15.

In addition, in the example provided in this application, a plurality of protrusions 125 are provided on the plate surface of the first spacer plate 12, grooves 1411 corresponding to the protrusions 125 are provided on the top of the fins 141, and the protrusions 125 may extend into the grooves 1411 and be abutted against bottom walls of the grooves 1411. The protrusions 125 fit with the grooves 1411, so that an area of contact between the fins 141 and the first spacer plate 12 can be increased. As a result, the cooling medium experiences relatively large flow resistance when flowing through contact surfaces of the first spacer plate 12 and the fins 141, so that more cooling media can flow through the channel between adjacent fins 141. This helps improve heat exchange efficiency between the cooling medium and the first cooling plate 14.

It may be understood that, in another example, grooves may alternatively be provided on the plate surface of the first spacer plate 12, and protrusions may alternatively be provided on the top of the fins 141. In actual application, shapes, a quantity, and an arrangement of the grooves or protrusions may be properly set according to an actual requirement, and details are not described herein.

It should be noted that, in the example provided in this application, the heat dissipator 10 is designed with an approximately symmetrical structure. That is, the heat dissipator 10 further includes the second spacer plate 13 and the second cooling plate 15. The structure of the first spacer plate 12 is basically the same as the structure of the second spacer plate 13, and the structure of the second cooling plate 15 is basically the same as the structure of the first cooling plate 14. In addition, the first spacer plate 12 and the second spacer plate 13 are opposite to each other relative to the base body 11, and the second cooling plate 15 and the first cooling plate 14 are opposite to each other relative to the base body 11.

For the structure of the second spacer plate 13, refer to the first spacer plate 12. For a manner of disposing the second spacer plate 13 and the base body 11, refer to the manner of disposing the first spacer plate 12 and the base body 11. Details are not described herein. In addition, for the structure of the second cooling plate 15, refer to the second cooling plate 15. For a manner of disposing the second cooling plate 15 and the base body 11, refer to the manner of disposing the first cooling plate 14 and the base body 11. Details are not described herein.

In brief, in the example provided in this application, the spacer plates are disposed in a one-to-one correspondence with the heat exchange cavities 103, and the spacer plate is located between the heat exchange cavity 103 and the liquid distribution cavity 101 and between the heat exchange cavity 103 and the liquid collection cavity 102.

In the foregoing example, each of the heat exchange cavities 103 is provided with a window for mounting a cooling plate. However, in actual application, each of the heat exchange cavities 103 may be provided with one, two, or more windows, and each window is provided with a cooling plate that seals the window.

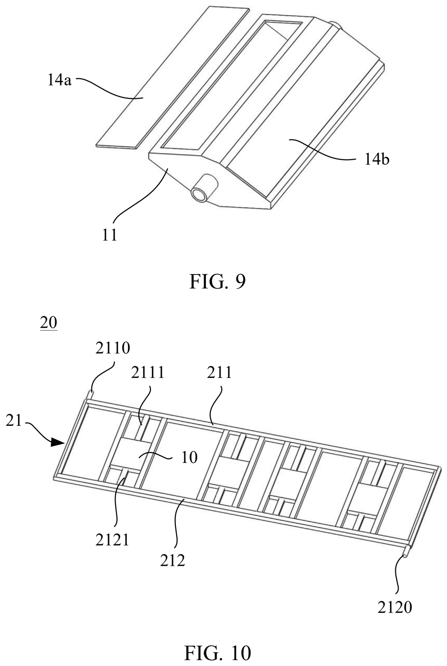

For example, as shown in FIG. 9, in an example provided in this application, a cross section of the heat dissipator 10 may be approximately diamond-shaped. Two heat exchange cavities are provided inside the heat dissipator 10, and each of the heat exchange cavities is provided with two windows. For example, one of the heat exchange cavities of the heat dissipator 10 is provided with two windows, the two windows are provided with a cooling plate 14a and a cooling plate 14b respectively, and each of the cooling plates is provided with one heat dissipation surface.

Each of the cooling plates is provided with a heat dissipation surface. An increase in a quantity of cooling plates can effectively increase a quantity of configured heat dissipation surfaces of the heat dissipator 10, so that effective heat dissipation can be provided for more to-be-cooled components.

It may be understood that, in the example provided in this application, the heat dissipation surfaces of the cooling plate 14a and the cooling plate 14b are both flat surfaces. However, in another example, the heat dissipation surface may alternatively be a V-shaped surface or another surface. This is not limited in this application.

In addition, in actual application, a plurality of heat dissipators 10 may alternatively be used together.

For example, as shown in FIG. 10, an embodiment of this application further provides a heat dissipation apparatus 20, including a frame 21 and heat dissipators 10. The frame 21 is provided with a liquid inlet pipeline 211 and a liquid outlet pipeline 212. The liquid inlet pipeline 211 is connected to liquid inlet ends of the heat dissipators 10 through pipes 2111, and the liquid outlet pipeline 212 is connected to liquid outlet ends of the heat dissipators 10 through pipes 2121. In addition, the liquid inlet pipeline 211 is provided with a main liquid inlet 2110, and the liquid outlet pipeline 212 is provided with a main liquid outlet 2120. The cooling medium may enter the liquid inlet pipeline 211 from the main liquid inlet 2110, flow into the corresponding heat dissipators 10 through the pipes 2111 respectively, be discharged into the liquid outlet pipeline 212 through the corresponding pipes 2121, and finally be discharged from the main liquid outlet 2120.

In the example provided in this application, the heat dissipation apparatus 20 includes four heat dissipators 10, and the four heat dissipators 10 are connected in parallel. This can effectively ensure temperature uniformity between different heat dissipators 10, effectively improve heat dissipation performance of the heat dissipation apparatus 20, and achieve proper utilization of a cooling capacity. In addition, the four heat dissipators 10 are approximately in a same plane. This can effectively reduce a thickness of the heat dissipation apparatus 20, to allow the heat dissipation apparatus 20 to be used in a scenario in which space is relatively limited and to help improve a scope of application of the heat dissipation apparatus 20. The heat dissipation apparatus 20 provided in this application includes four heat dissipators 10, and each of the heat dissipators 10 is provided with two heat dissipation surfaces. When a to-be-cooled component (for example, a chip) is disposed on each of the heat dissipation surfaces, the heat dissipation apparatus 20 can cool eight to-be-cooled components. Therefore, a relatively large quantity of to-be-cooled components can be cooled in limited space.

It may be understood that, in another example, a quantity of heat dissipators 10 included in the heat dissipation apparatus 20 and an arrangement of the heat dissipators 10 may be properly adjusted according to an actual requirement, and details are not described herein.

In actual application, a heat dissipator or a heat dissipation apparatus may be used in various types of scenarios such as an electronic device, a network node, a data center, or a vehicle.

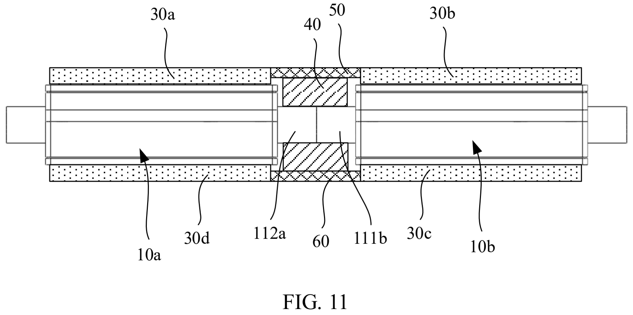

As shown in FIG. 11, an example in which the heat dissipator is used in a data center is used, and the data center may include a chip and a heat dissipator. Specifically, there may be two heat dissipators: a heat dissipator 10a and a heat dissipator 10b, and an upper surface and a lower surface of each of the heat dissipators are heat dissipation surfaces. A chip 30a, a chip 30b, a chip 30c, and a chip 30d in the data center are thermally attached to the four heat dissipation surfaces respectively.

In addition, in the example provided in this application, the heat dissipator 10a and the heat dissipator 10b may be cascaded. To be specific, a liquid outlet end 112a of the heat dissipator 10a may be communicated with a liquid inlet end 111b of the heat dissipator 10b, and the heat dissipator 10a and the heat dissipator 10b may be connected to each other through a fastener 40, to ensure reliability of connection between the heat dissipator 10a and the heat dissipator 10b. The fastener 40 may be specifically a clamp, a collar, or the like. In actual application, a specific type of the fastener 40 may be properly selected base body on an actual situation. This is not limited in this application.

In addition, in the example provided in this application, the chip 30a and the chip 30b may be communicatively connected to each other through a connector 50, and the chip 30c and the chip 30d may be communicatively connected to each other through a connector 60. The connector 50 and the connector 60 may be specifically cables, circuit boards, or the like. Specific types of the connector 50 and the connector 60 are not limited in this application.

In addition, in actual application, a manner of connection between different heat dissipators and an arrangement of the different heat dissipators may be flexibly selected and set according to an actual requirement, and details are not described herein.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipator, comprising a base body, wherein the base body is provided with a liquid inlet end and a liquid outlet end; and further comprising:
a liquid distribution cavity, wherein the liquid distribution cavity is located in the base body, and a first end of the liquid distribution cavity is communicated with the liquid inlet end;
a liquid collection cavity, wherein the liquid collection cavity is located in the base body, and a first end of the liquid collection cavity is communicated with the liquid outlet end; and
a heat exchange cavity, wherein the heat exchange cavity is located in the base body and is provided with a liquid inlet and a liquid outlet, the liquid inlet is communicated with the liquid distribution cavity, and the liquid outlet is communicated with the liquid collection cavity; and
a plurality of heat exchange cavities are provided, and an outer surface of each of the heat exchange cavities is provided with a heat dissipation surface.

2. The heat dissipator according to claim 1, wherein the heat dissipator further comprises a cooling plate; and
the base body is provided with a window in communication with the heat exchange cavity, the cooling plate seals the window, and the heat dissipation surface is located on a surface that is of the cooling plate and that is away from the heat exchange cavity.

3. The heat dissipator according to claim 2, wherein for one heat exchange cavity, the base body is provided with a plurality of windows in communication with the heat exchange cavity, and each of the windows is provided with a cooling plate that seals the window.

4. The heat dissipator according to claim 2 or 3, wherein the heat dissipator further comprises a plurality of spacer plates;
the plurality of spacer plates are disposed in a one-to-one correspondence with the plurality of heat exchange cavities, and each of the spacer plates is located between the corresponding heat exchange cavity and the liquid distribution cavity and between the corresponding heat exchange cavity and the liquid collection cavity; and
both the liquid inlet and the liquid outlet are provided on the spacer plate.

5. The heat dissipator according to claim 4, wherein the spacer plate has a first plate surface facing the heat exchange cavity, and the cooling plate has a second plate surface facing the heat exchange cavity;
a plurality of protruding fins are provided on the second plate surface, and a channel for a coolant to flow through is provided between adjacent fins; and
a top of each of the fins is abutted against the first plate surface.

6. The heat dissipator according to claim 5, wherein a protrusion or a groove is provided on the second plate surface.

7. The heat dissipator according to any one of claims 1 to 6, wherein the heat dissipator further comprises a baffle plate, and the baffle plate separates the liquid collection cavity from the liquid distribution cavity.

8. The heat dissipator according to claim 7, wherein the heat dissipator is provided with two heat exchange cavities, and the two heat exchange cavities are symmetric to each other;
the baffle plate is a U-shaped plate, and an opening end of the baffle plate is communicated with the liquid inlet end;
the heat dissipator comprises a first spacer plate and a second spacer plate, the first spacer plate is located on a first side edge of the baffle plate and is attached to the first side edge, and the second spacer plate is located on a second side edge of the baffle plate and is attached to the second side edge; and
the liquid collection cavity and the liquid distribution cavity are on one side of the first spacer plate, and one of the heat exchange cavities is on the other side of the first spacer plate; and the liquid collection cavity and the liquid distribution cavity are on one side of the second spacer plate, and the other of the heat exchange cavities is on the other side of the second spacer plate.

9. A heat dissipation apparatus, comprising a frame and at least one heat dissipator according to any one of claims 1 to 8, wherein the heat dissipator is disposed in the frame; and
the frame is provided with a liquid inlet pipeline and a liquid outlet pipeline, the liquid inlet pipeline is communicated with the liquid inlet end, and the liquid outlet pipeline is communicated with the liquid outlet end.

10. An electronic device, comprising: a to-be-cooled component, and the heat dissipator according to any one of claims 1 to 8 or the heat dissipation apparatus according to claim 9, wherein the to-be-cooled component is thermally attached to the heat dissipation surface.
